# EUROPEAN PATENT APPLICATION

(11) **EP 4 723 863 A1**
(43) Date of publication of application: **08.04.2026**
(21) Application number: 25201345.3
(22) Date of filing: 10.09.2025
(51) Int. Cl.: H10W 70/60

(54) **SEMICONDUCTOR DEVICE WITH INTEGRATED STACK CAPACITOR AND METHOD OF MANUFACTURING THE SAME**

(30) Priority: 01.10.2024 US 202418903515
(71) Applicant: Samsung Electronics Co., Ltd., Suwon-si, Gyeonggi-do 16677 (KR)
(72) Inventor: SHI, Jin, San Jose, CA, 95134 (US); YANG, Jin, San Jose, CA, 95134 (US); KIM, WooPoung, San Jose, CA, 95134 (US); JEONG, Sangnam, San Jose, CA, 95134 (US)
(74) Representative: Kuhnen & Wacker Patent- und Rechtsanwaltsbüro PartG mbB

(57) **Abstract**

Provided is a semiconductor device (1) including a substrate (210) including a through via, a first redistribution layer (100) on a first surface of the substrate (210), a second redistribution layer (300) on a second surface, opposite to the first surface, of the substrate (210), a semiconductor chip (10) on a second surface of the second redistribution layer (300), and one or more capacitors (50) included in at least one of the substrate (210), the first redistribution layer (100), and the second redistribution layer (300).

## Description

### BACKGROUND

### 1. Field

One or more embodiments of the present disclosure relate to a method of manufacturing a semiconductor device with an integrated stack capacitors (ISC) and an apparatus thereof.

### 2. Description of Related Art

According to the development of the electronics industry and the needs of users, a semiconductor device may need to perform larger number of functions, which increases power distribution system noise due to voltage droops and may limit the performance of the semiconductor device.

Therefore, an effective power delivery network (PDN) noise decoupling solution is needed for high-performance semiconductor devices.

Information disclosed in this Background section has already been known to the inventors before achieving the disclosure of the present application or is technical information acquired in the process of achieving the disclosure. Therefore, it may contain information that does not form the prior art that is already known to the public.

### SUMMARY

One or more embodiments provide a method of manufacturing a semiconductor device with a silicon interposer and an integrated stack capacitor, and an apparatus thereof.

One or more embodiments provide a hybrid adaptive decoupling optimization method to mitigate PDN droop and high frequency noise.

One or more embodiments provide a hybrid adaptive decoupling method employing an on-die de-capacitor and an integrated stack capacitor (ISC).

According to an aspect of an embodiment, there is provided a substrate including a through via, a first redistribution layer on a first surface of the substrate, a second redistribution layer on a second surface, opposite to the first surface, of the substrate, a semiconductor chip on a second surface of the second redistribution layer, and one or more capacitors included in at least one of the substrate, the first redistribution layer, and the second redistribution layer.

According to another aspect of an embodiment, there is provided a method of manufacturing a semiconductor device, the method including providing a substrate including through vias, providing a first redistribution layer on a first surface of the substrate, providing a second redistribution layer on a second surface of the substrate, providing one or more capacitors in at least one of the substrate, the first redistribution layer, and the second redistribution layer, and providing a semiconductor chip.

According to still another aspect of an embodiment, there is provided an electronic system including at least one memory configured to store computer-readable instructions and a plurality of data, and at least one processor configured to execute the computer-readable instructions and implement a plurality of computing operations using the plurality of data, wherein the at least one processor includes a semiconductor device including a substrate including a through via, a first redistribution layer on a first surface of the substrate, a second redistribution layer on a second surface of the substrate, a semiconductor chip on a second surface of the second redistribution layer, and one or more capacitors included in at least one of the substrate, the first redistribution layer, and the second redistribution layer.

### BRIEF DESCRIPTION OF DRAWINGS

The above and/or other aspects, features, and advantages of one or more embodiments of the disclosure will be more apparent from the following description taken in conjunction with the accompanying drawings, in which:
FIG. 1 illustrates a block diagram of a according to one or more embodiments;
FIG. 2 illustrates a voltage droop occurring during a power supply in a semiconductor device;
FIG. 3 illustrates a semiconductor device according to one or more embodiments;
FIG. 4 illustrates a semiconductor device according to one or more other embodiments;
FIG. 5 illustrates a semiconductor device according to one or more other embodiments;
FIG. 6 illustrates a circuit diagram of a semiconductor device according to one or more embodiments;
FIG. 7A illustrates an integrated stacked capacitor according to one or more embodiments, and FIG. 7B illustrates a cross section of an integrated stacked capacitor according to one or more embodiments;
FIGS. 8A and 8B illustrate plan view of an integrated stacked capacitor based on different sizes according to one or more embodiments;
FIGS. 9A and 9B illustrate a graph of an impedance and a capacitance dependency of an integrated stacked capacitor array; FIGS. 9C and 9D illustrate examples of an impedance of an integrated stack capacitor array; FIG. 9E illustrates a comparison of the impedance change based on frequency of a related capacitor and an integrated stacked capacitor; and FIG. 9F illustrates a comparison of an impact on a power distribution network impedance of an integrated stacked capacitor according to one or more embodiments;
FIG. 10 illustrates a flowchart of a method of manufacturing a semiconductor device according to one or more embodiments;
FIG. 11 illustrates a flowchart of a method to optimize noise decoupling in a PDN system according to one or more embodiments;
FIG. 12A illustrates a graph of a PDN noise based on PDN impedance; FIG. 12B illustrates a comparison of PDN noise for different capacitors; FIG. 12C illustrates a voltage droop and high frequency noise mitigation according to one or more embodiments compared to a related embodiment;
FIG. 13 is a schematic diagram illustrating an electronic device including at least one of semiconductor devices shown in FIGS. 3-5, according to one or more embodiments; and
FIG. 14 illustrates a schematic block diagram of an electronic system according to one or more embodiments.

### DETAILED DESCRIPTION

The one or more embodiments described herein are examples, and thus, the present disclosure is not limited thereto, and may be realized in various other forms. Each of the one or more embodiments provided in the following description is not excluded from being associated with one or more features of another example or another embodiment also provided herein or not provided herein but consistent with the present disclosure. For example, even if matters described in a specific example or example embodiment are not described in a different example or example embodiment thereto, the matters may be understood as being related to or combined with the different example or embodiment, unless otherwise mentioned in descriptions thereof.

In addition, it should be understood that all descriptions of principles, aspects, examples, and one or more embodiments are intended to encompass structural and functional equivalents thereof. In addition, these equivalents should be understood as including not only currently well-known equivalents but also equivalents to be developed in the future, that is, all devices invented to perform the same functions regardless of the structures thereof.

It will be understood that when an element, component, layer, pattern, structure, region, or so on (hereinafter collectively "element") of a semiconductor device is referred to as being "over," "above," "on," "below," "under," "beneath," "connected to" or "coupled to" another element the semiconductor device, it can be directly over, above, on, below, under, beneath, connected or coupled to the other element or an intervening element(s) may be present. In contrast, when an element of a semiconductor device is referred to as being "directly over," "directly above," "directly on," "directly below," "directly under," "directly beneath," "directly connected to" or "directly coupled to" another element of the semiconductor device, there are no intervening elements present. Like numerals refer to like elements throughout this disclosure.

Spatially relative terms, such as "over," "above," "on," "upper," "below," "under," "beneath," "lower," "top," and "bottom," and the like, may be used herein for ease of description to describe one element's relationship to another element(s) as illustrated in the figures. It will be understood that the spatially relative terms are intended to encompass different orientations of a semiconductor device in use or operation in addition to the orientation depicted in the figures. For example, if the semiconductor device in the figures is turned over, elements described as "below" or "beneath" other elements would then be oriented "above" the other elements. Thus, the term "below" can encompass both an orientation of above and below. The semiconductor device may be otherwise oriented (rotated 90 degrees or at other orientations) and the spatially relative descriptors used herein interpreted accordingly.

As used herein, expressions such as "at least one of," when preceding a list of elements, modify the entire list of elements and do not modify the individual elements of the list. For example, the expression, "at least one of a, b, and c," should be understood as including only a, only b, only c, both a and b, both a and c, both b and c, or all of a, b, and c. Herein, when a term "same" is used to compare a dimension of two or more elements, the term may cover a "substantially same" dimension.

It will be understood that, although the terms "first," "second," "third," "fourth," etc. may be used herein to describe various elements, these elements should not be limited by these terms. These terms are only used to distinguish one element from another element. Thus, a first element discussed below could be termed a second element without departing from the teachings of the present disclosure.

It will be also understood that, even if a certain step or operation of manufacturing an apparatus or structure is described later than another step or operation, the step or operation may be performed later than the other step or operation unless the other step or operation is described as being performed after the step or operation. It will be understood that any of the components or any combination of the components described herein may be used to perform one or more of the operations of the flowcharts. Further, all operations are example operations, and may include various additional steps.

One or more embodiments are described herein with reference to cross-sectional illustrations that are schematic illustrations of the one or more embodiments (and intermediate structures). As such, variations from the shapes of the illustrations as a result, for example, of manufacturing techniques and/or tolerances, are to be expected. Thus, the one or more embodiments should not be construed as limited to the particular shapes of regions illustrated herein but are to include deviations in shapes that result, for example, from manufacturing. For example, an implanted region illustrated as a rectangle will, typically, have rounded or curved features and/or a gradient of implant concentration at its edges rather than a binary change from implanted to non-implanted region. Likewise, a buried region formed by implantation may result in some implantation in the region between the buried region and the surface through which the implantation takes place. Thus, the regions illustrated in the figures are schematic in nature and their shapes are not intended to illustrate the actual shape of a region of a device and are not intended to limit the scope of the present disclosure. Further, in the drawings, the sizes and relative sizes of layers and regions may be exaggerated for clarity.

Integrated circuits, such as microprocessors, are formed and implemented to operate at a determined set of supply voltages. As more functions are integrated in a single integrated circuit (or a "chip"), the on-chip noise condition due to a switching activity on the chip may increase. Power supply and power distribution system noise, especially voltage droops due to a large step current may increase which may limit the speed at which circuits in a processor may operate. For example, higher operating frequencies require logic circuits in a processor core to operate at higher speed, which may be achieved when the processor is operating at a higher supply voltage. However, using a supply voltage that is lower than a required level may cause timing failures or other erroneous operations of the processor core. **In** addition, due to voltage droops in a power distribution network of the processor, internal core circuits of the processor may fall outside of their operational limits. Therefore, a more effective PDN noise decoupling method is needed.

One or more embodiments provide a hybrid adaptive decoupling optimization method to mitigate noise caused by voltage drooping and to employ an on-die de-capacitor and a integrated stack capacitor (ISC).

For the sake of brevity, general elements to semiconductor devices may or may not be described in detail herein.

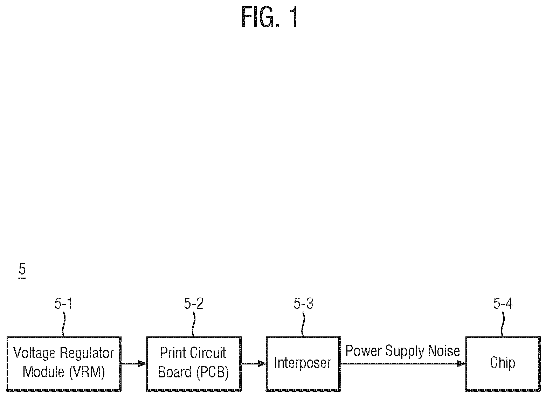

FIG. 1 illustrates a block diagram of a power delivery network (PDN) system according to one or more embodiments.

Referring to FIG. 1, the PDN system 5 may include a voltage regulator module (VRM) 5-1, a printed circuit board (PCB) 5-2, a semiconductor interposer 5-3, and a semiconductor chip 5-4. For example, power may be supplied from the VRM 5-1 through the PCB 5-2 and the semiconductor interposer 5-3 to the semiconductor chip 5-4. When power is being supplied, noise created during the power supply may also be provided.

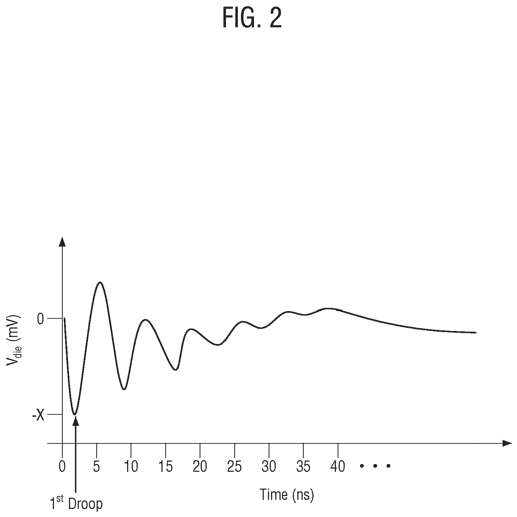

FIG. 2 illustrates a graph showing a voltage droop occurring during power supply in a semiconductor device.

As illustrated in FIG. 2, a first voltage droop may occur in which a voltage supplied to the semiconductor chip drops to a certain level, for example, -x mV. When the voltage droop occurs to a level that is lower than a required level for operation of the semiconductor device, timing failures or other erroneous operations may occur. In addition, due to voltage droops in a power distribution network of a processor, internal core circuits of the processor may fall outside of their operational limits.

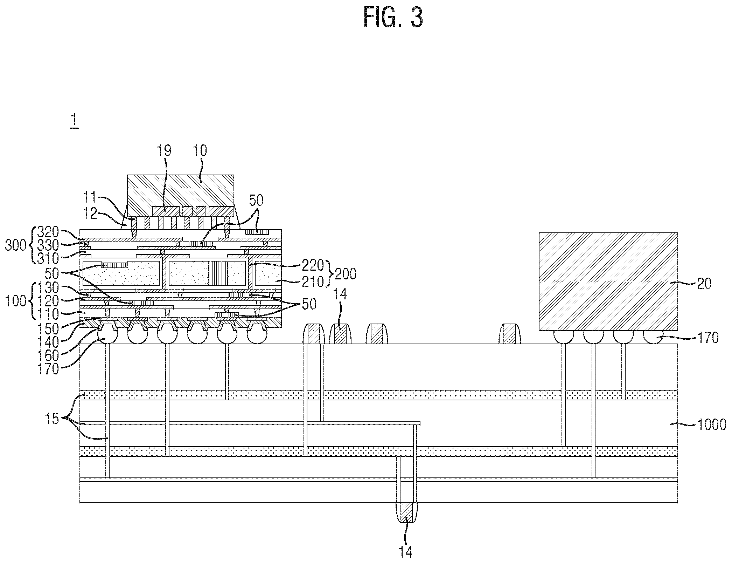

FIG. 3 illustrates a semiconductor device according to one or more embodiments.

Referring to FIG. 3, a semiconductor device 1 may include a semiconductor chip 10, a first redistribution layer 100, a silicon interposer 200, and a second redistribution layer 300 that are provided on a package substrate 1000. For example, the package substrate 1000 may be a printed circuit board (PCB). The semiconductor device 1 may also include a voltage regulator module (VRM) 20 and capacitors 14 provided on the package substrate 1000. The package substrate 1000 may include wirings 15 that electrically connect the semiconductor chip 10, the VRM 20, and capacitors 14 to each other. The semiconductor device 1 may be implemented as a semiconductor package.

It is to be understood here that the VRM 20, the package substrate (e.g., PCB) 1000, the silicon interposer 200, and the semiconductor chip 10 shown in FIG. 3 may represent or correspond to the VRM 5-1, the PCB 5-2, the semiconductor interposer 5-3, and the semiconductor chip 5-4, respectively, in FIG. 1.

Herein, a direction parallel to a main surface of the first redistribution layer 100 may be referred to as a horizontal direction (X direction and/or Y direction), and a direction perpendicular to the horizontal direction (X direction and/or Y direction) and normal to the main surface of the first redistribution layer 100 may be referred to as a vertical direction (Z direction).

Referring to FIG. 3, the first redistribution layer 100 may include one or more first redistribution insulating layers 110, first wiring patterns 120, and first vias 130. The first wiring patterns 120 and the first vias 130 may be included or enclosed in the first redistribution insulating layers 110. The first redistribution insulating layers 110 may be stacked in the vertical direction. The first redistribution insulating layers 110 may include an organic insulating material, such as an Ajinomoto redistribution film (ABF), oxide, nitride, a photo-imageable dielectric (PID) resin prepared by combining epoxy resin and photoinitiators, and may further include photosensitive polyimide and/or inorganic fillers, etc., not being limited thereto.

The first wiring patterns 120 and the first vias 130 may be provided as conductive patterns in the first redistribution insulating layers 110. The first wiring patterns 120 may extend in the horizontal direction and be provided at different vertical levels within the first redistribution insulating layers 110. The first vias 130 may interconnect some of the first wiring patterns 120 to each other in the vertical direction and electrically connect the first wiring patterns 120 to other elements outside the first redistribution layer 100.

According to embodiments, at least some of the first wiring patterns 120 may be integrally provided together with some of the first vias 130. For example, the first wiring patterns 120 and the first vias 130, that contact each other, may be integrally formed as a single structure.

According to embodiments, the first vias 130 may have any suitable shape including, for example, a tapered shape in which the horizontal widths of the first vias 130 decrease in the vertical direction away from the semiconductor chip 10 which may facilitate the manufacturing process. However, embodiments are not limited thereto.

The first wiring patterns 120 and the first vias 130 may include, for example, metals such as copper (Cu), aluminum (Al), tungsten (W), titanium (Ti), tantalum (Ta), indium (In), molybdenum (Mo), manganese (Mn), cobalt (Co), tin (Sn), nickel (Ni), magnesium (Mg), rhenium (Re), beryllium (Be), gallium (Ga), ruthenium (Ru), and an alloy thereof but is not limited thereto.

The semiconductor device 1 may further include a passivation layer 140, an under bump metallurgy (UBM) layer 150, and a conductive layer 160. For example, the passivation layer 140 may have a single-layer structure and may be provided on a first surface of the first redistribution layer 100. In another embodiment, the passivation layer 140 may have a multilayer structure. The passivation layer 140 may at least partially cover a second surface and a side surface of the conductive layer 160 and may expose a first surface of the conductive layer 160. In addition, the UBM layers 150 may be provided on a portion of the second surface of the passivation layer 140. It is to be understood here that a "first surface" and a "second surface" may refer to a bottom (or lower) surface and a top (or upper) surface of a corresponding element in the vertical direction, respectively.

The passivation layer 140 may include an insulating material, for example, an ABF, silicon oxide, silicon nitride, phosphosilicate glass (PSG), borophosphosilicate glass (BPSG), fluorosilicate glass (FSG), and a combination thereof.

The UBM layer 150 may electrically connect the conductive layer 160 with other components of the semiconductor device 1 such as an external connection terminal 170. In addition, the UBM layer 150 may prevent the external connection terminal 170 from cracking due to a thermal shock between the external connection terminal 170 and the first redistribution layer 100, to thereby improve the reliability of the semiconductor device 1. The UBM layer 150 may include a conductive material, for example, copper (Cu), aluminum (Al), silver (Ag), gold (Au), tungsten (W), titanium (Ti), and a combination thereof.

The conductive layer 160 may be provided on the passivation layer 140, and the first surface of the conductive layer 160 may be exposed from the first surface of the passivation layer 140. The conductive layer 160 may include conductive patterns that are spaced apart in the first horizontal direction or the second horizontal direction. In FIG. 3, the conductive layer 160 is shown as single layered conductive patterns that are provided at a single vertical level, however, embodiments are not limited thereto, and the conductive layer 160 may be provided as a multilayered conductive pattern that is provided at different vertical levels depending on embodiments. The conductive layer 160 may include, for example, a metal, such as copper (Cu), aluminum (Al), tungsten (W), titanium (Ti), tantalum (Ta), indium (In), molybdenum (Mo), manganese (Mn), cobalt (Co), tin (Sn), nickel (Ni), magnesium (Mg), rhenium (Re), beryllium (Be), gallium (Ga), and ruthenium (Ru), and an alloy thereof but is not limited thereto.

The external connection terminal 170 may be provided on a first surface of the UBM layer 150. The external connection terminal 170 may be configured to connect the first redistribution layer 100 and an external device electrically and/or physically. According to an embodiment, the external connection terminal 170 may include, for example, a solder ball, a conductive bump, and a flip-chip connection structure having a grid array such as a pin grid array, a ball grid array, and a land grid array. For example, as illustrated in FIG. 3, the external connection terminal 170 may be electrically connected to the UBM layer 150 and may be electrically connected to wirings 15 in the package substrate 1000. However, embodiments are not limited thereto, and the external connection terminal 170 may connect the UBM layer 150 to external devices such as, for example, a module substrate and a system board.

A silicon interposer 200 may be provided on a second surface of the first redistribution layer 100. The silicon interposer 200 may include a silicon substrate 210 and through silicon vias (TSV) 220 vertically penetrating the silicon substrate 210. As another embodiment, in lieu of the through silicon via, the silicon interposer 200 may include a through organic via (TOV), a coaxial via (COV), or a copper (Cu) via-in-via. However, embodiments are not limited thereto, and in lieu of a silicon substrate, a glass substrate may be included to form a glass interposer.

The through silicon vias 220 may be provided between the first redistribution layer 100 and the second redistribution layer 300, and provide an electrical connection path between the first redistribution layer 100 and the second redistribution layer 300. The through silicon vias 220 may include a conductive material including, for example, copper (Cu), aluminum (Al), silver (Ag), gold (Au), tungsten (W), titanium (Ti), and a combination thereof.

The through silicon vias 220 may have a first surface and a second surface spaced apart from each other in the vertical direction. The second surface of the through silicon vias 220 may be coplanar with or at a level above a second surface of the silicon substrate 210 in the vertical direction, and the first surface of the through silicon vias 220 may be coplanar with or at a level below a first surface of the silicon substrate 210 in the vertical direction. The through silicon vias 220 may be at least partially in contact with the first wiring patterns 120 exposed on a second surface of the uppermost first redistribution insulating layer 110. For example, the first surfaces of the through silicon vias 220 may be bonded and connected to a second surface of the first wiring patterns 120.

The through silicon vias 220 may have, for example, a cylindrical shape. A diameter of each of the through silicon vias 220 in the horizontal direction may be constant along the vertical direction. In another embodiment, each of the through silicon vias 220 may have a tapered shape having a diameter in the horizontal direction that varies along the vertical direction depending on the manufacturing conditions.

The second redistribution layer 300 may be positioned on the silicon interposer 200. The second redistribution layer 300 may include one or more second redistribution insulating layers 310, second wiring patterns 320, and second vias 330. The second wiring patterns 320 and the second vias 330 may be included or enclosed in the second redistribution insulating layers 310.

The second redistribution insulating layers 310 may be stacked in the vertical direction. The second redistribution insulating layers 310 may include an insulating material, such as ABF, oxide, and nitride, etc., not being limited thereto.

The second wiring patterns 320 and the second vias 330 may be provided as conductive patterns in the second redistribution insulating layers 310. The second wiring patterns 320 may extend in the horizontal direction and be provided at different vertical levels within the second redistribution insulating layers 310. The second vias 330 may interconnect some of the second wiring patterns 320 to each other in the vertical direction and electrically connect the second wiring patterns 320 to other elements outside the second redistribution layer 300.

According to embodiments, at least some of the second wiring patterns 320 may be integrally provided together with some of the second vias 330. For example, the second wiring patterns 320 and the second vias 330, that contact each other, may be integrally formed as a single and continuous structure without an interface therebetween.

According to embodiments, the second vias 330 may have a tapered shape in which the horizontal widths of the second vias 330 decrease in the vertical direction away from the semiconductor chip 10.

The second wiring patterns 320 and the second vias 330 may include, for example, metals such as copper (Cu), aluminum (Al), tungsten (W), titanium (Ti), tantalum (Ta), indium (In), molybdenum (Mo), manganese (Mn), cobalt (Co), tin (Sn), nickel (Ni), magnesium (Mg), rhenium (Re), beryllium (Be), gallium (Ga), ruthenium (Ru), and an alloy thereof but is not limited thereto.

The semiconductor chip 10 may be provided on a second surface of the second redistribution layer 300. Connection members 11 may be provided between a first surface of the semiconductor chip 10 and the second surface of the second redistribution layer 300. The first surface of the semiconductor chip 10 may include connection pads. The connection pads of the semiconductor chip 10 may be electrically connected to the second redistribution layer 300 through the connection members 11. An underfill layer 12 may be provided adjacent to and to surround the connection members 11 between the semiconductor chip 10 and the second redistribution layer 300. The underfill layer 12 may include a slant outer surface. The underfill layer 12 may include an epoxy resin or two or more silicon hybrid materials.

For example, the semiconductor chip 10 may be a logic chip including, for example, a logic chip such as a central processor (CPU), a graphics processor (GPU), a field programmable gate array (FPGA), a digital signal processor (DSP), an application-specific integrated circuit (ASIC). However, embodiments are not limited thereto. As another example, semiconductor chip 10 may be a system-on-chip (SOC), or a memory chip such as a dynamic random access memory (DRAM) chip and a NAND chip.

On-chip capacitors 19 may be provided on a first surface of the semiconductor chip 10. The on-chip capacitors 19 may be embedded in the semiconductor chip 10 and first surfaces of the on-chip capacitors 19 may be substantially coplanar with or at a level above the first surface of the semiconductor chip 10 in the vertical direction. The on-chip capacitors 19 may be connected to the second redistribution layer 300 through the connection members 11.

The semiconductor device 1 may further include integrated stacked capacitors (ISC) 50. Due to a relatively small size of the ISC 50 having a size dimension (thickness, width, length, etc.) that may be equal to or less than 2 µm, the ISC 50 may be provided at various locations in the semiconductor device 1. For example, referring to FIG. 3, in the vertical direction, as a thickness of the first redistribution insulating layer 110 or the second redistribution insulating layer 310 may range from about 10 to 25 µm and may be greater than a thickness of an ISC 50 in the vertical direction, one or more ISC 50 may be embedded in one of the first redistribution insulating layers 110 and one of the second redistribution insulating layers 310. In addition, one or more ISC 50 may be placed at a surface layer of the first redistribution insulating layers 110 as a land side capacitor and a surface layer of the second redistribution layer 300 as a chip side capacitor.

In addition, one or more ISC 50 may be provided in a groove or a cavity formed in the silicon substrate 210. For example, cavities having a depth of about 3 to 25 µm, which is less than a thickness of the silicon substrate 210, may be formed in at least one of a first surface and a second surface of the silicon substrate 210 during a laser grooving process for manufacturing the through silicon via 220 in the silicon substrate 210. Thus, when placing an ISC 50 in the one or more cavities of the silicon substrate 210, a separate step of providing a space to include the ISC 50 in the silicon substrate 210 may be omitted and the manufacturing process may be more simplified. However, embodiments are not limited thereto, and a thickness of the ISC 50 may be adjusted to be the same as a thickness of the silicon substrate 210 in the vertical direction.

Referring to FIG. 3, the VRM 20 may be provided on a second surface of the package substrate 1000 adjacent to the semiconductor chip 10 and connected to wirings 15. The external connection terminals 170 may also be provided between the VRM 20 and the package substrate 1000, and may electrically connect the VRM 20 to the package substrate 1000 through wirings 15.

The semiconductor device 1 also includes capacitors 14 provided on at least one of a first surface and a second surface of the package substrate 1000 and connected to the wirings 15 to be electrically connected to the semiconductor chip 10 and/or the VRM 20. The capacitors 14 may include board capacitors and bulk capacitors, but embodiments are not limited thereto.

Referring to FIG. 3, as the ISCs 50 may be embedded in one or more of the first redistribution insulating layers 110, the second redistribution insulating layer 310, and the silicon substrate 210, the ISCs 50 may be provided closer to the semiconductor chip 10, compared to a semiconductor device including, for example, a multilayer ceramic capacitor (MLCC). Thus, a vertical size of the semiconductor device 1 may be reduced and impedance of a power distribution network (PDN) for multiple frequency ranges, in particular, relatively high frequency ranges may be lowered, and a voltage droop may be reduced to improve performance of the semiconductor device 1.

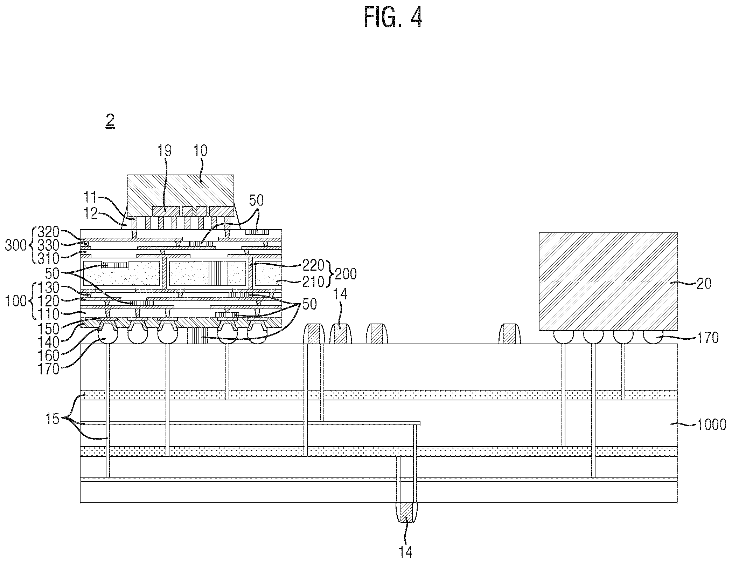

FIG. 4 illustrates a semiconductor device according to one or more other embodiments. Descriptions overlapping with previous drawings will be omitted for the sake of brevity and the differences will mainly be described.

Referring to the semiconductor device 2 in FIG. 4, in comparison with the semiconductor device 1 illustrated in FIG. 3, in addition to the ISCs 50 included in one or more of the first and second redistribution insulating layers 110 and 310 and the silicon interposer 200, one or more additional ISCs 50 may be provided at the first surface of the first redistribution layer 100, adjacent to the external connection terminal 170. For example, an additional ISC 50 may be provided between the first redistribution layer 100 and the package substrate 1000 and connected to wirings 15. As another example, the additional ISC 50 may be provided on a first surface of the passivation layer 140. As still another example, the additional ISC 50 may contact the first surface of the passivation layer 140 and the second surface of the package substrate 1000. As yet another example, the additional ISC 50 may be provided at a side of the external connection terminal 170, or between two adjacent external connection terminals 170 between the passivation layer 140 and the package substrate 1000.

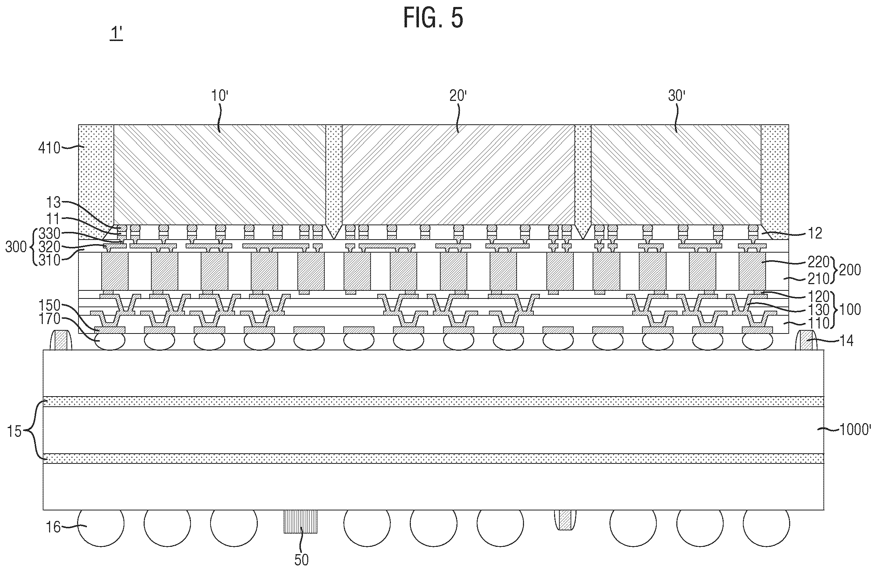

FIG. 5 illustrates a semiconductor device according to one or more other embodiments. Descriptions overlapping with previous drawings will be omitted for the sake of brevity and the differences will mainly be described.

Referring to FIG. 5, a semiconductor device 1' may include a first semiconductor chip 10', a second semiconductor chip 20', a third semiconductor chip 30', a first redistribution layer 100, a silicon interposer 200, and a second redistribution layer 300. The semiconductor device may also include a package substrate 1000' including wirings 15. The package substrate 1000' may be, for example, a printed circuit board (PCB).

The semiconductor device 1' may include a package having a fan-out structure. A size of the first redistribution layer 100 and a size of the second redistribution layer 300 may be larger than a size of the first semiconductor chip 10', the second semiconductor chip 20', and the third semiconductor chip 30'. The size of the first redistribution layer 100 and the second redistribution layer 300 may be the same as a size of the semiconductor device 1'.

The first redistribution layer 100 may include one or more first redistribution insulating layers 110, first wiring patterns 120, and first vias 130. The first wiring patterns 120 and the first vias 130 may be included or enclosed in the first redistribution insulating layers 110. The first redistribution insulating layers 110 may be stacked in the vertical direction. The first redistribution insulating layers 110 may include an insulating material, such as an ABF, oxide, nitride, a photo-imageable dielectric (PID) resin prepared by combining epoxy resin and photoinitiators, and may further include photosensitive polyimide and/or inorganic fillers, not being limited thereto.

The first wiring patterns 120 and the first vias 130 may be provided as conductive patterns in the first redistribution insulating layers 110. The first wiring patterns 120 may be provided to extend in the horizontal direction in the first redistribution insulating layers 110. The first vias 130 may interconnect some of the first wiring patterns 120 to each other and electrically connect the first wiring patterns 120 to other elements outside the first redistribution layer 100.

According to embodiments, at least some of the first wiring patterns 120 may be integrally provided together with some of the first vias 130. For example, the first wiring patterns 120 and the first vias 130, which are in contact with the second surface of the first wiring patterns 120, may be integrally formed as a single structure.

According to embodiments, the first vias 130 may have any suitable shape including, for example, a tapered shape in which the horizontal widths of the first vias 130 decrease in the vertical direction away from the first semiconductor chip 10', the second semiconductor chip 20', and the third semiconductor chip 30' depending on the manufacturing conditions.

The first wiring patterns 120 and the first vias 130 may include, for example, metals such as copper (Cu), aluminum (Al), tungsten (W), titanium (Ti), tantalum (Ta), indium (In), molybdenum (Mo), manganese (Mn), cobalt (Co), tin (Sn), nickel (Ni), magnesium (Mg), rhenium (Re), beryllium (Be), gallium (Ga), ruthenium (Ru), and an alloy thereof but is not limited thereto.

The semiconductor device 1' may further include an under bump metallurgy (UBM) layers 150. The UBM layers 150 may be connected to at least one of the first wiring patterns 120 and the first vias 130, and may electrically connect the first redistribution layer 100 with other components of the semiconductor device 1' such as an external connection terminals 170. In addition, the UBM layers 150 may prevent the external connection terminals 170 from cracking due to the thermal shock between the external connection terminals 170 and the first redistribution layer 100, to thereby improve the reliability of the semiconductor device 1'. The UBM layers 150 may include a conductive material, for example, copper (Cu), aluminum (Al), silver (Ag), gold (Au), tungsten (W), titanium (Ti), and a combination thereof.

The external connection terminals 170 may be respectively provided on the first surface of the UBM layers 150. The external connection terminals 170 may be configured to connect the first redistribution layer 100 and an external device electrically and/or physically. According to an embodiment, the external connection terminals 170 may include, for example, a solder ball, a conductive bump, and a flip-chip connection structure having a grid array such as a pin grid array, a ball grid array, and a land grid array. The external connection terminals 170 may be electrically connected to the UBM layers 150 and may be electrically connected to the external device such as a module substrate, a system board, and a printed circuit board. The semiconductor device 1' may further include a passivation layer and a conductive layer similar to those illustrated in FIG. 3 between the UBM layer 150 and the external connection terminal 170.

A silicon interposer 200 may be provided on a second surface of the first redistribution layer 100. The silicon interposer 200 may include a silicon substrate 210 and through silicon vias 220 vertically penetrating the silicon substrate 210. As another embodiment, in lieu of the through silicon via, the silicon interposer 200 may include a through organic via (TOV), a coaxial via (COV), or a copper (Cu) via-in-via. In addition, in lieu of a silicon substrate, a glass substrate may be included and form a glass interposer.

The through silicon vias 220 may be provided between the first redistribution layer 100 and the second redistribution layer 300, and provide an electrical connection path between the first redistribution layer 100 and the second redistribution layer 300. The plurality of through silicon vias 220 may include a conductive material including, for example, copper (Cu), aluminum (Al), silver (Ag), gold (Au), tungsten (W), titanium (Ti), and a combination thereof.

The through silicon vias 220 may have a first surface and a second surface spaced apart from each other in the vertical direction. The second surface of the through silicon vias 220 may be coplanar with or at a level above a second surface of the silicon substrate 210 in the vertical direction, and the first surface of the through silicon vias 220 may be coplanar with or at a level above the first surface of the silicon substrate 210 in the vertical direction. The through silicon vias 220 may be at least partially in contact with at least one of the first vias 130 and first wiring patterns 120 exposed on a second surface of the uppermost first redistribution insulating layers 110. For example, the first surfaces of the through silicon vias 220 may be bonded and connected to a second surface of the first wiring patterns 120.

The through silicon vias 220 may have, for example, a cylindrical shape. A diameter of each of the through silicon vias 220 in the horizontal direction may be constant along the vertical direction. In another embodiment, each of the through silicon vias 220 may have a tapered shape having a diameter in the horizontal direction that varies along the vertical direction depending on the manufacturing conditions.

The second redistribution layer 300 may be provided on the silicon interposer 200. The second redistribution layer 300 may include one or more second redistribution insulating layers 310 and second vias 330. The second redistribution layer 300 may also include second wiring patterns 320.

The second redistribution insulating layers 310 may be stacked in the vertical direction. The second redistribution insulating layer 310 may include an insulating material, such as a photo-imageable dielectric (PID) resin, and may further include photosensitive polyimide and/or inorganic fillers, not being limited thereto.

The second wiring patterns 320 and the second vias 330 may be provided as conductive patterns in the second redistribution insulating layer 310. The second wiring patterns 320 may be provided to extend in the horizontal direction in the second redistribution insulating layer 310. The second vias 330 may penetrate one or more second redistribution insulating layer 310 in the vertical direction, to thereby contact and be electrically connected with some of the second wiring patterns 320.

According to embodiments, at least some of the second wiring patterns 320 may be integrally provided together with some of the second vias 330. For example, the second wiring patterns 320 and the second vias 330, which are in contact with the second surface of the second wiring patterns 320, may be integrally formed as a single structure.

According to embodiments, the second vias 330 may have a tapered shape in which the horizontal widths of the second vias 330 decrease in the vertical direction away from the first semiconductor chip 10, the second semiconductor chip 20', and the third semiconductor chip 30'.

The second wiring patterns 320 and the second vias 330 may include, for example, metals such as copper (Cu), aluminum (Al), tungsten (W), titanium (Ti), tantalum (Ta), indium (In), molybdenum (Mo), manganese (Mn), cobalt (Co), tin (Sn), nickel (Ni), magnesium (Mg), rhenium (Re), beryllium (Be), gallium (Ga), ruthenium (Ru), and an alloy thereof but is not limited thereto.

The first semiconductor chip 10', the second semiconductor chip 20', and the third semiconductor chip 30' may be provided on the second surface of the second redistribution layer 300. A first surface of the first semiconductor chip 10', a first surface of the second semiconductor chip 20', and a first surface of the third semiconductor chip 30' may include connection members 11 and connection pads 13 that electrically connect the first semiconductor chip 10', the second semiconductor chip 20', and the third semiconductor chip 30' to the second redistribution layer 300. For example, the first semiconductor chip 10' may be electrically connected to the second redistribution layer 300 through the connection members 11 and connection pads 13. An underfill layer 12 may be provided adjacent to and to surround the connection members 11 and connection pads 13 between the first semiconductor chip 10' and the second redistribution layer 300. Connection members 11 and connection pads 13 may be provided between a first surface of the second semiconductor chip 20' and a second surface of the second redistribution layer 300. The second semiconductor chip 20' may be electrically connected to the second redistribution layer 300 through the connection members 11 and connection pads 13. An underfill layer 12 may be provided adjacent to and to surround the connection members 11 between the second semiconductor chip 20' and the second redistribution layer 300. Connection members 11 and connection pads 13 may be provided between a first surface which is an active surface of the third semiconductor chip 30' and the second redistribution layer 300. The third semiconductor chip 30' may be electrically connected to the second redistribution layer 300 through the connection members 11 and connection pads 13. An underfill layer 12 may be provided adjacent to and to surround the connection members 11 between the third semiconductor chip 30' and the second redistribution layer 300. The underfill layer 12 may include a slant outer surface depending on the manufacturing conditions. The underfill layer 12 may include an epoxy resin or two or more silicon hybrid materials.

For example, the second semiconductor chip 20' may be a logic chip such as a central processor (CPU), a graphics processor (GPU), a field programmable gate array (FPGA), a digital signal processor (DSP), an application-specific integrated circuit (ASIC), and a system-on-chip (SOC), and the first semiconductor chip 10' and the third semiconductor chip 30' may be a memory chip such as a high bandwidth memory (HBM) chip, a dynamic random access memory (DRAM) chip, and a NAND chip. However, embodiments are not limited thereto.

The semiconductor device 1' may also include a mold layer 410 provided on the second surface of the second redistribution layer 300 and surround the first semiconductor chip 10', the second semiconductor chip 20', the third semiconductor chip 30', and the underfill layers 12. The mold layer 410 be an epoxy mold compound and may include, for example, epoxy mold resin including silicon fillers.

The semiconductor device 1' may include capacitors 14 provided on at least one of the first and second surfaces of the package substrate 1000' and connected to the wirings 15 to be electrically connected to one or more of the first semiconductor chip 10', the second semiconductor chip 20', the third semiconductor chip 30', and external connection terminals 190 provided on the first surface of the package substrate 1000'.

The semiconductor device 1' may also include one or more ISCs 50 provided on the first surface of the package substrate 1000' adjacent to the external connection terminals 190. As still another example, the additional ISC 50 may contact the first surface of the package substrate 1000'. As yet another example, the additional ISC 50 may be provided at a side of the external connection terminal 190, or between two adjacent external connection terminals 190.

According to one or more embodiments, ISCs 50 may also be provided at various locations in the semiconductor device 1'. For example, similar to ISCs 50 in FIGS. 3 and 4, additional ISCs 50 may be embedded in one or more of the first redistribution insulating layers 110, the second redistribution insulating layer 310, and the silicon substrate 210. As another example, additional ISCs 50 may be placed at a surface layer of the first redistribution insulating layers 110 as a land side capacitor and a surface layer of the second redistribution layer 300 as a chip side capacitor. In addition, one or more ISC 50 may be provided in a cavity formed on a surface of the silicon substrate 210. A thickness of the ISC 50 embedded in the silicon substrate 210 may be less than or equal to the thickness of the silicon substrate 210 in the vertical direction.

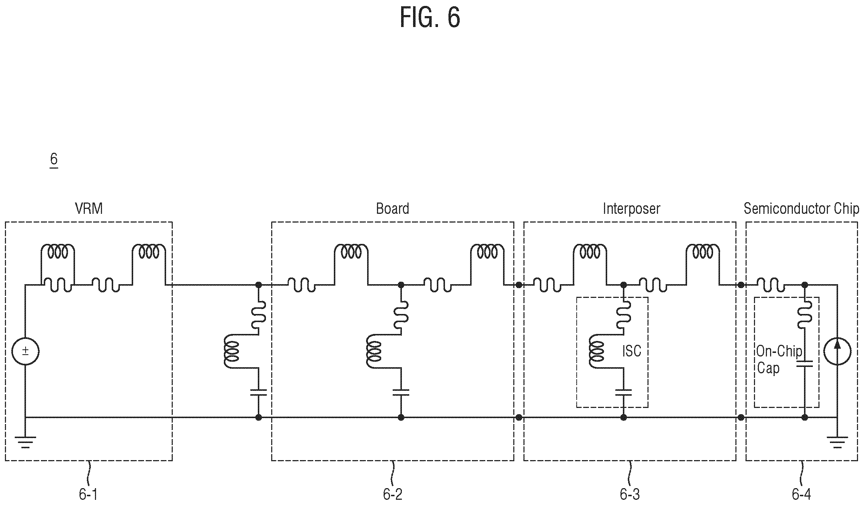

FIG. 6 is a circuit diagram of a PDN system according to one or more embodiments.

As illustrated in FIG. 6, the PDN system may include a voltage regulator module (VRM) 6-1 connected to a circuit of a printed circuit board 6-2, a circuit of an interposer 6-3, and a circuit of a chip 6-4. The interposer circuit may include an ISC and the chip circuit may include an on-chip capacitor.

It is to be understood here that the VRM 20, the package substrate (e.g., PCB) 1000, the silicon interposer 200, and the semiconductor chip 10 shown in FIG. 3 may represent or correspond to the circuit of VRM 6-1, the circuit of PCB 6-2, the circuit of the semiconductor interposer 6-3, and the circuit of the semiconductor chip 6-4, respectively.

As an ISC and an on-chip capacitor are included in the PDN system, a voltage droop may be more effectively prevented.

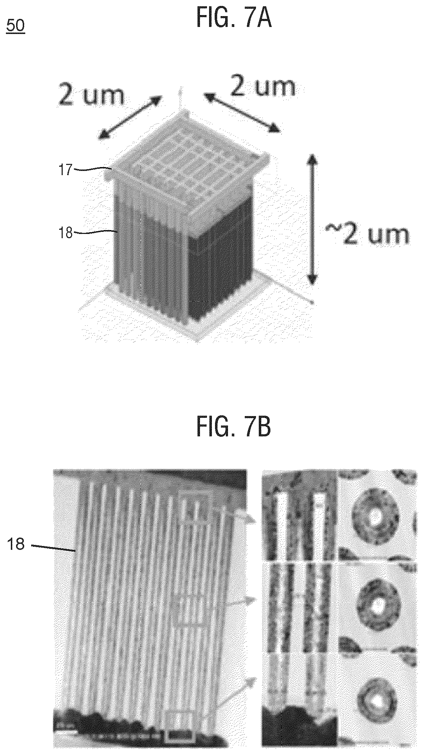

FIGS. 7A and 7B illustrate an integrated stacked capacitor according to one or more embodiments.

Referring to FIG. 7A, an ISC 50 may include a concave array of silicon based capacitive vias 18, respectively having a vertical cylinder shape on a silicon backplane, that are connected to a metal substrate or a polysilicon substrate 17. For example, the metal substrate or the polysilicon substrate 17 may be electrically and/or physically connected to a back end of line (BEOL) layer in a semiconductor package. A thickness in the vertical direction of an ISC may range from less than 2 µm to 850 µm by thinning the silicon backplane. However, embodiments are not limited thereto. For example, the vertical cylinder array may have a size of 2x2x2 µm³, and a unit ISC 50 may include capacitive vias that include a through hole. A value of capacitance of a silicon based ISC may be about hundreds of nF/mm². Accordingly, an ISC may have a relatively small size and relatively high capacitance density, compared to, for example, a multilayer ceramic capacitor (MLCC).

FIG. 7B illustrates a cross section of a unit ISC 50 included in a semiconductor device according to one or more embodiments. As illustrated in FIG. 7B, an ISC includes an array of capacitive vias having a circular shape with a through hole when viewed from a top plan view in the vertical direction. As illustrated in FIG. 7B, a horizontal width of each capacitive via 18 may decrease in the vertical direction depending on the manufacturing condition. However, embodiments are not limited thereto.

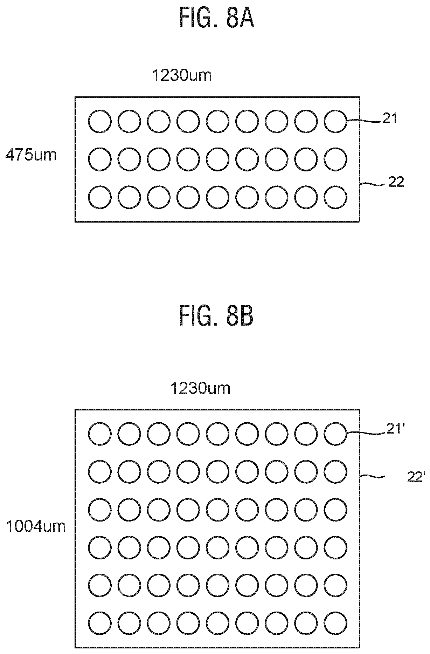

FIGS. 8A and 8B illustrate a plan views an ISC array according to one or more embodiments.

For example, FIG. 8A illustrates a top plan view in the vertical direction of an ISC array in a mass production measuring 1230um x 475 um in which an array metal bumps 21 are provided on a substrate 22. Each of the metal bumps 21 may cover multiple unit ISCs 50 and be connected to, for example, a power source or be grounded. FIG. 8B illustrates a top plan view in the vertical direction of an ISC array in a mass production measuring 1230um x 1004um in which an array of bumps 21' are provided on a substrate 22'. Each of the metal bumps 21' may cover multiple unit ISCs 50 and be connected to, for example, a power source or be grounded.

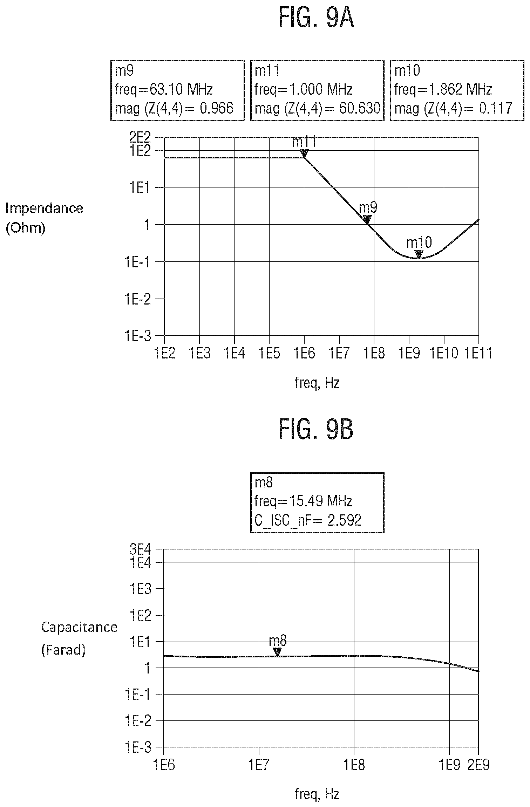

FIGS. 9A through 9F illustrate graphs showing performance of an ISC according to one or more embodiments.

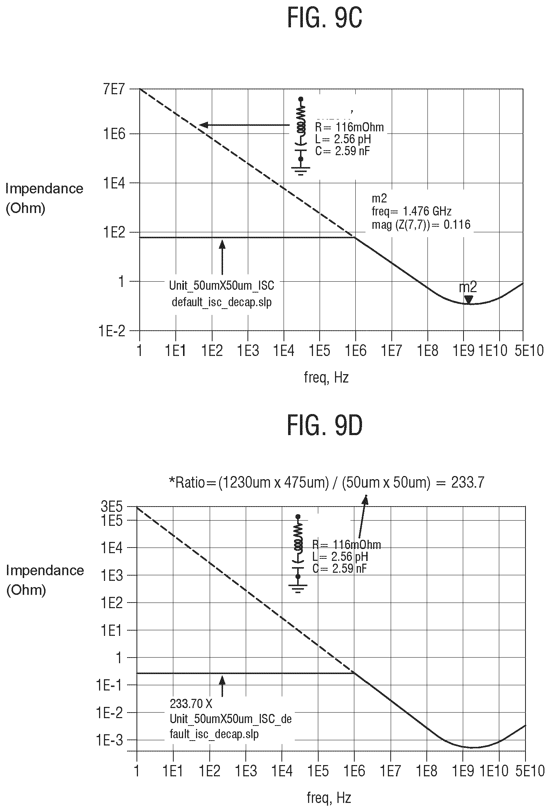

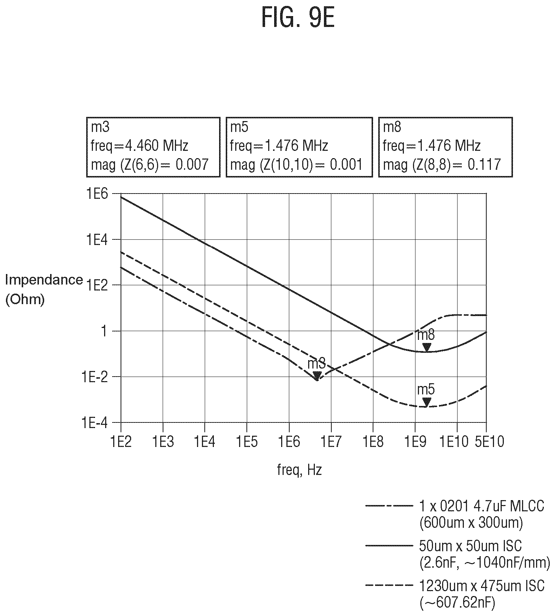

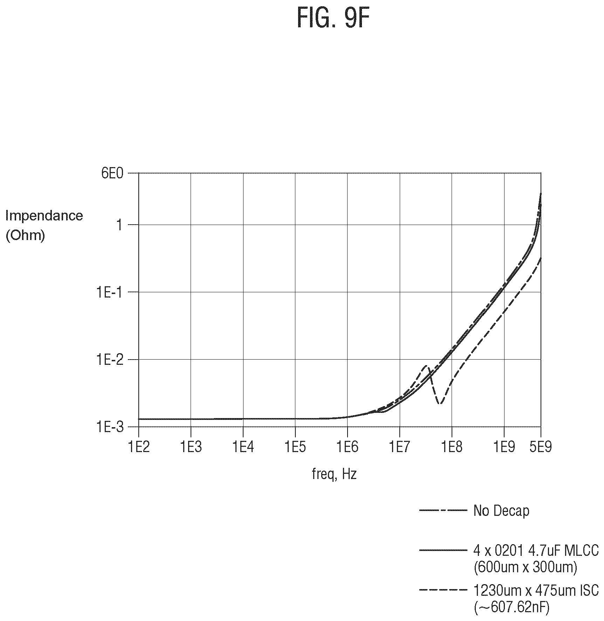

FIG. 9A illustrates a graph of an impedance and 9B illustrate a graph of a capacitance dependency of a unit ISC 50 which has a size of 50um x 50um being equivalent to 2.59nF with a relatively small frequency dependency across a frequency range of 1MHz ~ 2+ GHz. As shown in FIG. 9A, the impedance of an ISC array tends to decrease from point m11 in which the frequency is 1.0 MHz to point m10 in which the frequency is 1.862 MHz. Further, as illustrated in FIG. 9B, the capacitance of the ISC array decreases at a higher frequency. FIGS. 9C and 9D further illustrate examples of an impedance of ISC arrays deceasing at a relatively high frequency. FIG. 9E illustrates a an impedance of an ISC array being lower than an impedance of a surface mount MLCC decoupling capacitors at a higher frequency range such as 1.476 MHz. FIG. 9F illustrates an impedance of an ISC array compared to an MLCC and a circuit with no on-die capacitor being included. As shown in FIG. 9F, the impedance of the ISC array at a higher frequency range is the lowest, which shows that an ISC has higher performance in a higher frequency range.

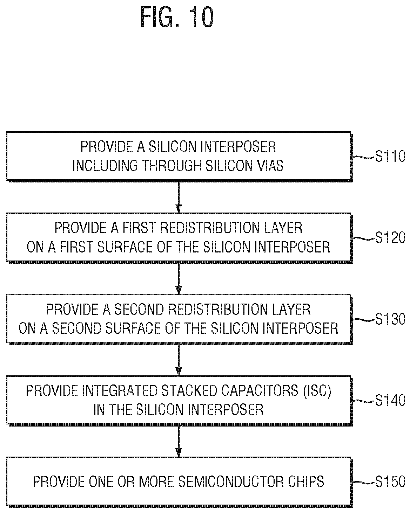

FIG. 10 illustrates a flowchart of manufacturing a semiconductor device according to one or more embodiments.

In operation S110, a silicon interposer including a silicon substrate and through silicon vias vertically penetrating the silicon substrate is formed. The silicon substrate is laser processed to form cavities and/or cavities on a second surface and a first surface of the silicon substrate, and a portion of the cavities and/or cavities are wet etched or dry etched to form through silicon tunnels penetrating the silicon substrate. The through silicon tunnels are filled with metal material to form through silicon vias. The metal material may include a conductive material including, for example, copper (Cu), aluminum (Al), silver (Ag), gold (Au), tungsten (W), titanium (Ti), and a combination thereof, but embodiments are not limited thereto.

In operation S120, a first redistribution layer is formed on the first surface of the silicon interposer. A first redistribution insulating layer is laminated on the first surface of the silicon substrate and the ISC, and first wiring patterns are formed on first redistribution insulating layer. First vias are formed to penetrate the first redistribution insulating layers, and may interconnect first wiring patterns provided at different vertical levels and connect one or more first wiring patterns to the ISC. Additional layers of the first redistribution insulating layers with first wiring patterns and first vias may be formed on a first surface of the first redistribution insulating layer. In addition, ISCs may be embedded in different levels of the first redistribution insulating layers and connected to at least one of a first via and a first wiring pattern. A passivation layer may be formed on a lowermost first redistribution insulating layer. An under bump metallurgy (UBM) layer and a conductive layer may be formed, and an external connection terminal may be formed on the conductive layer to connect the semiconductor device to an external device.

In operation S130, a second redistribution layer is formed on the second surface of the silicon interposer. A second redistribution insulating layer is laminated on the second surface of the silicon substrate and the ISC, and second wiring patterns are formed on second redistribution insulating layer. Second vias are formed to penetrate the second redistribution insulating layer, and may interconnect second wiring patterns provided at different vertical levels and connect one or more second wiring patterns to the ISC. Additional layers of the second redistribution insulating layers with second wiring patterns and second vias may be formed on a second surface of the second redistribution insulating layer. In addition, ISCs may be embedded in different levels of the second redistribution insulating layers and connected to at least one of a second via and a second wiring pattern.

At operation S140, one or more ISCs may be provided. According to embodiments, one or more ISCs may be included in at least one of a groove formed in the silicon substrate and a second surface or a first surface of the silicon substrate prior to forming the first redistribution layer and the second redistribution layer. The thickness of the ISC may be less than or equal to the thickness of the silicon substrate. In addition, ISCs may be embedded in a first redistribution insulating layer and a second redistribution insulating layer. According to one or more other embodiments, one or more ISCs may be provided on the first surface of the first redistribution layer or the first surface of a printed circuit board opposite to a semiconductor device.

At operation S150, one or more semiconductor chip may be provided. For example, a semiconductor chip may be provided on the first surface of the first redistribution layer and the second surface of the second redistribution layer. Connection members may be formed to connect the semiconductor chip with first and second wiring patterns included in the first and second redistribution layers. An underfill layer may fill spaces between the connection members. The semiconductor chip may be, for example, a logic die, an SOC chip, an HBM chip, a DRAM chip, an SRAM chip, etc., however, embodiments are not limited thereto. According to another embodiment, semiconductor chips may also be provided in a cavity formed in the silicon substrate prior to forming the first redistribution layer and the second redistribution layer. In addition, multiple silicon interposers may be stacked on top of each other, and directly connected to each other or connected to each other through external connection terminals therebetween.

As one or more ISCs may be embedded in the redistribution layers and the silicon substrate, one or more ISCs may be provided closer to the semiconductor chips, compared to a semiconductor device including, for example, a multilayer ceramic capacitor (MLCC). Thus, the vertical size of the semiconductor device may be reduced and the impedance of the power distribution network (PDN) for multiple frequency ranges, in particular, relatively high frequency ranges may be lowered, resulting in an improved he performance of the semiconductor device may be improved.

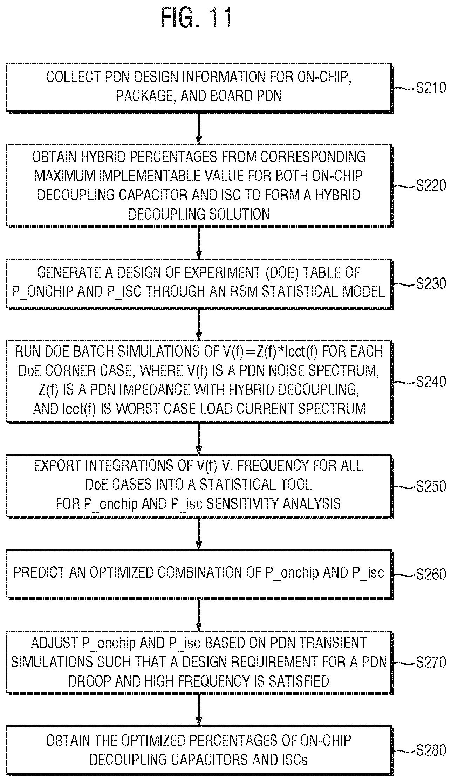

FIG. 11 illustrates a method to optimize noise decoupling in a PDN system according to one or more embodiments.

As shown in FIG. 11, in operation S210, PDN design information for a semiconductor chip, an interposer, and a package substrate such as a PCB is collected. In operation S220, hybrid percentages from corresponding maximum implementable value for both on-chip capacitor and an ISC array to form a decoupling noise method is obtained. In operation S230, a design of experiment (DoE) table of P_onchip and P_isc is generated through an RSM statistical model. In operation S240, DoE batch simulations of V(f)=Z(f)*Icct(f) for each DoE case is performed, where V(f) is a PDN noise spectrum, Z(f) is a PDN impedance decoupled based on the on-chip capacitor and an ISC, and Icct(F) is lowest case load current spectrum. In operation S250, integrations of V(f) versus frequency for all DoE cases are exported into a statistical tool for P_onchip and P_isc sensitivity analysis. In operation S260, an optimized combination of P_onchip and P_isc is estimated. In operation S270, P_onchip and P_isc is adjusted based on PDN transient simulations such that a configuration requirement for a PDN voltage droop and relatively high frequency is satisfied. In operation S280, the optimized percentages of on-chip decoupling capacitors and ISCs are obtained.

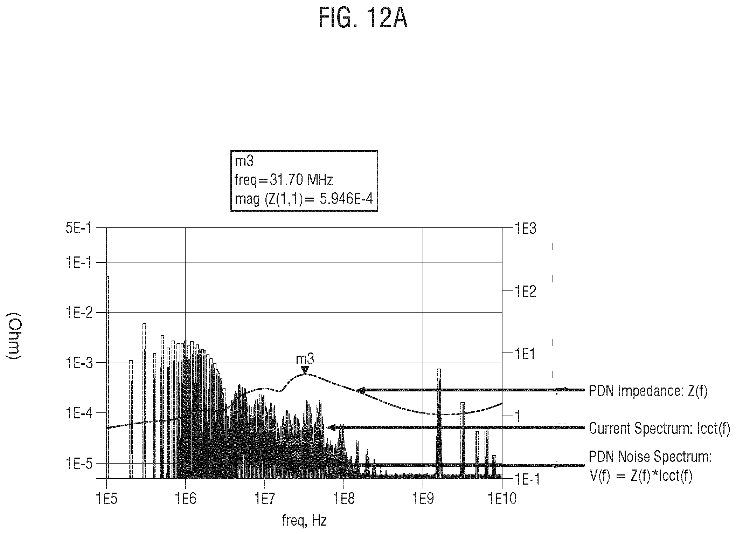

FIGS. 12A through 12C illustrate performance of an ISC array based on a change in the impedance and capacitance of an ISC array according to frequency according to one or more embodiments compared to a related embodiment based on the method described with respect to FIG. 11.

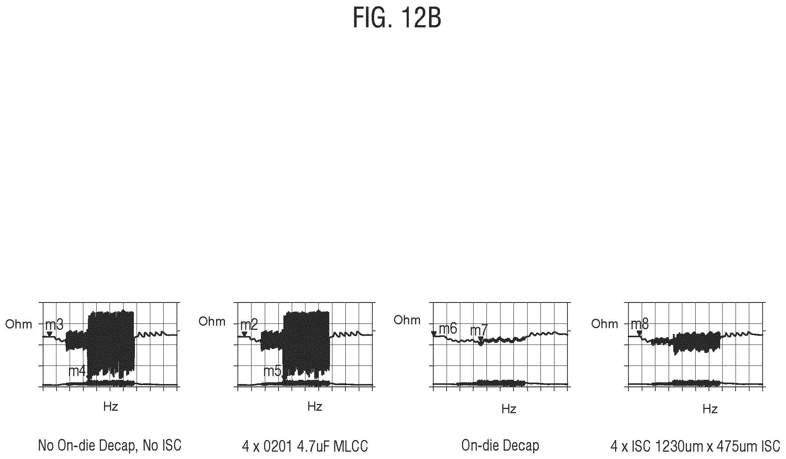

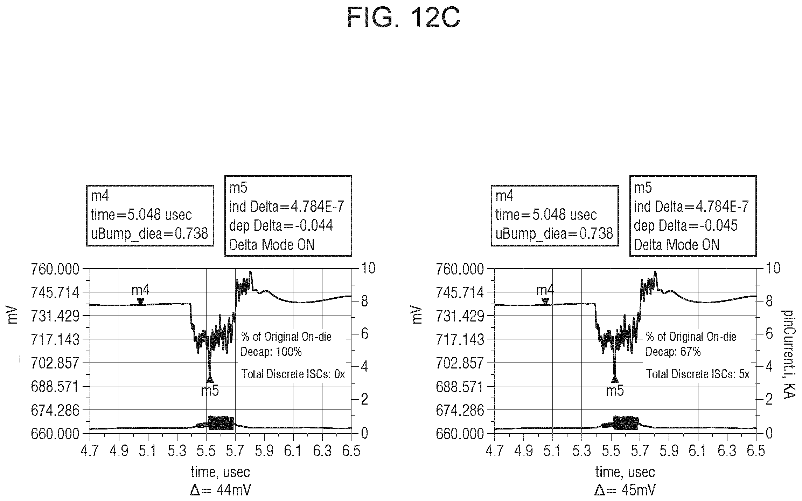

FIG. 12A illustrates a PDN noise V(f) construction from PDN impedance Z(f) and lowest case load current spectrum Icc(f). FIG. 12B illustrates a comparison of PDN impedance and noise for a semiconductor package including no on-die capacitor or ISC, an MLCC, an on-die capacitor, and an ISC. As shown in FIG. 12B, the semiconductor package including an ISC may have the lowest amount of noise. FIG. 12C illustrates an example of a sensitivity of on-chip capacitor and an ISC on a PDN noise and droop mitigation.

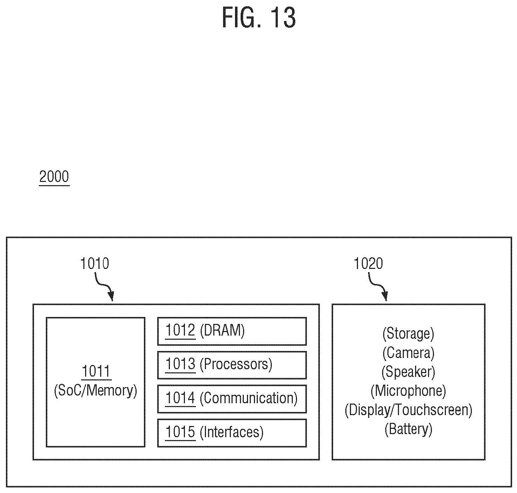

FIG. 13 is a schematic diagram illustrating an electronic device including at least one of semiconductor devices shown in FIGS. 3-5, according to one or more embodiments.

Referring to FIG. 13, an electronic device 2000 may include a printed circuit board (PCB) or motherboard 1010 on which a plurality of semiconductor devices 1011-1015 are mounted. The electronic device 2000 may also include a plurality of other components 1020.

The semiconductor device 1011 may include a plurality of chips such as system-on-chips (SoCs) and memory chips. The SoC may include at least one of a central processing unit (CPU), a graphic processing unit (GPU), an artificial intelligence (AI) module, a modem, one or more memory units, a power management unit, etc. to control overall operations of the electronic device 2000. The memory chips included in the semiconductor device 1011 may be one or more of a flash memory, a static random access memory (SRAM), a read-only-memory (ROM), etc. The other semiconductor devices 1012-1015 may include dynamic random access memory (DRAM) chips, various other processor chips, communication chips and interface chips, respectively. The communication chips included in the semiconductor device 1014 may be configured to also perform wireless or wire communication functions in association with the SoC. At least one of the semiconductor devices 1011-1015 may be implemented by one or more of the semiconductor devices shown in FIGS. 3-5.

The other components 1020 included in the electronic device 2000 may include a storage, a camera module, a speaker, a microphone, a display, a battery, etc. The storage may be configured to store user data. The storage may be an embedded multimedia card (eMMC), a solid state drive (SSD), a universal flash storage (UFS) device, etc. The display may be implemented to display data processed by the SoC and/or to receive data through a touchscreen panel of the display.

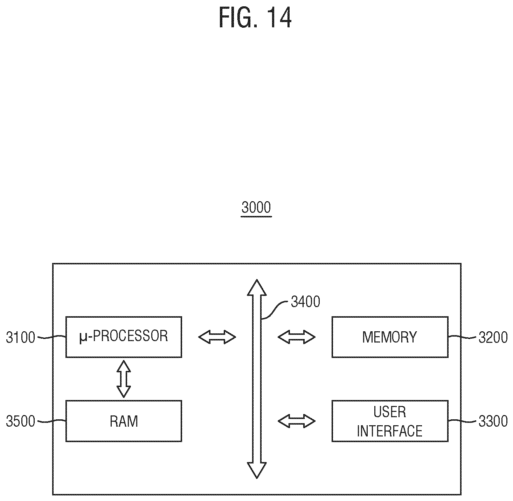

FIG. 14 illustrates a schematic block diagram of an electronic system according to one or more embodiments.

Referring to FIG. 14, an electronic system 3000 in accordance with an embodiment may include a microprocessor 3100, a memory 3200, and a user interface 3300 that perform data communication using a bus 3400. The microprocessor 3100 may include a central processing unit (CPU) or an application processor (AP). The electronic system 3000 may further include a random access memory (RAM) 3500 in direct communication with the microprocessor 3100. The microprocessor 3100 and/or the RAM 3500 may be implemented in a single module or package. The user interface 3300 may be used to input data to the electronic system 3000, or output data from the electronic system 3000. For example, the user interface 3300 may include a keyboard, a touch pad, a touch screen, a mouse, a scanner, a voice detector, a liquid crystal display (LCD), a micro light-emitting device (LED), an organic light-emitting diode (OLED) device, an active-matrix light-emitting diode (AMOLED) device, a printer, a lighting, or various other input/output devices without limitation. The memory 3200 may store operational codes of the microprocessor 3100, data processed by the microprocessor 3100, or data received from an external device. The memory 3200 may include a memory controller, a hard disk, or a solid state drive (SSD).

At least the microprocessor 3100, the memory 3200 and/or the RAM 3500 in the electronic system 3000 may include semiconductor devices as described in the above one or more embodiments.

It should be understood that one or more embodiments described herein should be considered in a descriptive sense only and not for purposes of limitation. Descriptions of features or aspects within each embodiment should typically be considered as available for other similar features or aspects in other embodiments.

## Claims

1. A semiconductor device (1, 2) comprising:
a substrate (210) comprising a through via (220);
a first redistribution layer (100) on a first surface of the substrate (210);
a second redistribution layer (300) on a second surface, opposite to the first surface, of the substrate (210);
a semiconductor chip (10) on a second surface of the second redistribution layer (300); and
one or more capacitors (50) included in at least one of the substrate (210), the first redistribution layer (100), and the second redistribution layer (300).

2. The semiconductor device (1, 2) according to claim 1, wherein the first redistribution layer (100) comprises a first redistribution insulating layer (110), a first wiring pattern (120), and a first via (130) connected to the first wiring pattern (120), and
wherein the second redistribution layer (300) comprises a second redistribution insulating layer (310), a second wiring pattern (320), and a second via (330) connected to the second wiring pattern (320).

3. The semiconductor device (1, 2) according to claim 2, wherein a capacitor among the one or more capacitors (50) is included in at least one of the first redistribution insulating layer (110) and the second redistribution insulating layer (310), and
wherein the capacitor is connected to at least one of the first wiring pattern (120), the first via (130), the second wiring pattern (320), and the second via (330).

4. The semiconductor device (1, 2) according to any one of the previous claims, wherein the substrate (210) comprises a cavity, and
wherein a capacitor, optionally a capacitor among the one or more capacitors (50), is included in the cavity.

5. The semiconductor device (1, 2) according to any one of the previous claims, further comprising:
a capacitor, optionally a capacitor among the one or more capacitors (50), on a first surface of the first redistribution layer (100).

6. The semiconductor device (1, 2) according to any one of the previous claims, further comprising:
a printed circuit board (1000) on a first surface of the first redistribution layer (100); and
a capacitor, optionally a capacitor among the one or more capacitors (50), on a first surface of the printed circuit board (1000).

7. The semiconductor device (1, 2) according to any one of the previous claims, wherein a capacitor, optionally a capacitor among the one or more capacitors (50), is included in the substrate (210).

8. The semiconductor device (1, 2) according to any one of the previous claims, further comprising:
a connection member (11) between the semiconductor chip (10) and the second redistribution layer (300),
wherein the connection member (11) contacts a capacitor, optionally a capacitor among the one or more capacitors (50).

9. The semiconductor device (1, 2) according to claim 8, wherein the one or more capacitors (50) are included in the semiconductor chip (10) and connected to the connection member (11).

10. The semiconductor device (1, 2) according to any one of the previous claims, wherein a thickness of each of the one or more capacitors (50) is less than or equal to a thickness of the substrate (210) in a vertical direction.

11. The semiconductor device (1, 2) according to any one of the previous claims, wherein a thickness of each of the one or more capacitors (50) is less than or equal to 2 µm.

12. A method of manufacturing a semiconductor device (1, 2), the method comprising:
providing (S110) a substrate (210) comprising through vias (220);
providing (S120) a first redistribution layer (100) on a first surface of the substrate (210);
providing (S130) a second redistribution layer (300) on a second surface, opposite to the first surface, of the substrate (210);
providing (S140) one or more capacitors (50) in at least one of the substrate (210), the first redistribution layer (100), and the second redistribution layer (300); and
providing (S150) a semiconductor chip (10) on a second surface of the second redistribution layer (300).

13. The method of claim 12, wherein providing (S120) the first redistribution layer (100) comprises providing a first redistribution insulating layer (110), a first wiring pattern (120), and a first via (130) connected to the first wiring pattern (120), and
wherein providing (S130) the second redistribution layer (300) comprises providing a second redistribution insulating layer (310), a second wiring pattern (320), and a second via (330) connected to the second wiring pattern (320).

14. The method of claim 13, wherein providing (S140) the one or more capacitors (50) comprises providing a capacitor, optionally a capacitor among the one or more capacitors (50), in at least one of the first redistribution insulating layer (110) and the second redistribution insulating layer (310), and
wherein the capacitor is connected to at least one of the first wiring pattern (120), the first via (130), the second wiring pattern (320), and the second via (330).

15. The method of any one of claims 12 to 14, further comprising providing a cavity in the substrate (210); and
providing a capacitor, optionally a capacitor among the one or more capacitors (50), in the cavity.
